(19) Europäisches Patentamt

European Patent Office

Office européen des brevets

(11) **EP 1 397 867 B1**

(12) **EUROPÄISCHE PATENTSCHRIFT**

(45) Veröffentlichungstag und Bekanntmachung des Hinweises auf die Patenterteilung:
**17.08.2005 Patentblatt 2005/33**

(21) Anmeldenummer: **02726080.1**

(22) Anmeldetag: **17.04.2002**

(51) Int Cl.$^7$: **H03M 7/36**, H03H 17/02

(86) Internationale Anmeldenummer:
**PCT/DE2002/001431**

(87) Internationale Veröffentlichungsnummer:
**WO 2002/095951 (28.11.2002 Gazette 2002/48)**

(54) **VERFAHREN UND VORRICHTUNG ZUR UNTERDRÜCKUNG VON GRENZZYKLEN BEI NOISE-SHAPING-FILTERN**

METHOD AND DEVICE FOR SUPPRESSION OF LIMITING CYCLES IN NOISE-SHAPING FILTERS

PROCEDE ET DISPOSITIF POUR ELIMINER DES CYCLES LIMITES LORS DU FILTRAGE DE MISE EN FORME DE BRUIT

(84) Benannte Vertragsstaaten:
**AT BE CH CY DE DK ES FI FR GB GR IE IT LI LU MC NL PT SE TR**

(30) Priorität: **22.05.2001 DE 10125000**

(43) Veröffentlichungstag der Anmeldung:
**17.03.2004 Patentblatt 2004/12**

(73) Patentinhaber: **Infineon Technologies AG**
**81669 München (DE)**

(72) Erfinder: **PILGRAM, Berndt**
**80798 München (DE)**

(74) Vertreter: **Lange, Thomas, Dr.**
**Patentanwälte**
**Lambsdorff & Lange,**
**Dingolfinger Strasse 6**
**81673 München (DE)**

(56) Entgegenhaltungen:
**WO-A-00/31879          DE-A- 19 912 447**
**DE-C- 4 408 768**

**Beschreibung**

Die Erfindung betrifft eine Vorrichtung sowie ein Verfahren zur Unterdrückung von Grenzzyklen bei der Rauschumformung und eignet sich insbesondere für den Einsatz in der Audiosignalverarbeitung.

Wenn ein Audiosignal mit einer Abtastrate ausgelesen wird, welche wesentlich höher ist als die gemäß dem Nyquist-Theorem erforderliche Abtastrate, so spricht man von einer überabtastung des Audiosignals. Mit einer derartigen Überabtastung und einer nachfolgenden Tiefpassfilterung lässt sich der Signal-Rausch-Abstand signifikant vergrößern. Das bei der Abtastung entstehende Quantisierungsrauschen liegt als gleichverteiltes weißes Rauschen in einem Frequenzbereich vor, dessen obere Grenzfrequenz aus der Abtastfrequenz ableitbar ist. Durch Überabtastung des Audiosignals kann erreicht werden, dass sich das weiße Rauschen bis zu einer oberen Grenzfrequenz erstreckt, die wesentlich höher ist als typische Audiofrequenzen. Dadurch ist im Audio-Frequenzbereich nurmehr ein geringer Teil der gesamten Rauschintensität zu finden. Mit einem Tiefpassfilter, der sämtliche Frequenzen oberhalb des typischen Audiofrequenzbandes unterdrückt, lässt sich daher ein Großteil des gleichverteilten Quantisierungsrauschens eliminieren. Der Signal-Rausch-Abstand des Audiosignals wird daher durch Überabtastung signifikant verbessert.

Zur weiteren Verbesserung des Signal-Rausch-Abstands sind sogenannte Noise-Shaping-Filter bekannt, welche meist aus zwei oder drei hintereinander angeordneten Filterstufen bestehen. Das überabgetastete Signal wird jeweils mit verschiedenen Koeffizienten multipliziert und zu den vorhergehenden Filterstufen zurückgekoppelt. Dadurch kann erreicht werden, dass das Rauschen "gefärbt" wird: Die Rauschintensität bei niedrigen Frequenzen wird reduziert, während die Rauschintensität bei höheren Frequenzen vergrößert wird. Die hochfrequenten Rauschanteile werden mittels des nachgeschalteten Tiefpasses eliminiert. Diese Rauschumformung bewirkt daher eine zusätzliche Verbesserung des Signal-Rausch-Abstands.

Bei der Verwendung von Noise-Shaping-Filtern kommt es wegen der in diesen Filtern vorgesehenen Rückkopplungen zu Grenzzyklen, die das Audiosignal überlagern. Die durch den Grenzzyklus verursachten harmonischen Komponenten machen sich als Pfeifgeräusche störend bemerkbar.

Zur Lösung dieses Problems ist in der deutschen Patentschrift DE 44 08 768 C1 sowie in der europäischen Patentschrift EP 0 673 114 B1 ein zweistufiges Noise-Shaping-Filter beschrieben, bei dem die Grenzzyklen mittels eines zusätzlichen Rückkopplungsblocks unterdrückt werden. Dieser Rückkopplungsblock bildet zusammen mit dem zweistufigen Noise-Shaping-Filter eine funktionelle Einheit. Das in diesen Patenten beschriebene Verfahren sowie die zugehörige Schaltungsanordnung ist daher nur für das beschriebene zweistufige Noise-Shaping-Filter anwendbar. Ein weiterer Nachteil ist, dass die vorgestellte Schaltungsanordnung zur Eliminierung der Grenzzyklen nur für Digitalfilter ausgelegt ist.

Aufgabe der Erfindung ist es, eine Vorrichtung sowie ein Verfahren zur Unterdrückung von Grenzzyklen zur Verfügung zu stellen, welche bzw. welches zusammen mit beliebigen Noise-Shaping-Filtern einsetzbar ist und insbesondere auch für die analoge Signalverarbeitung geeignet ist.

Diese Aufgabe der Erfindung wird durch eine Vorrichtung zur Unterdrückung von Grenzzyklen gemäß Anspruch 1, sowie durch ein Verfahren zur Unterdrückung von Grenzzyklen bei der Rauschumformung gemäß Anspruch 21 gelöst.

Die erfindungsgemäße Vorrichtung zur Unterdrückung von Grenzzyklen weist einen Filterblock zur Rauschumformung auf, welcher das Noise-Shaping durchführt. Darüber hinaus weist die Vorrichtung einen Addierer auf, an dessen erstem Eingang das Ergebnissignal des Filterblocks zur Rauschumformung anliegt, und an dessen zweitem Eingang ein Rückkopplungssignal anliegt. Das Ausgabesignal des Addierers wird einer Teilerstufe zugeführt, die dieses Ausgabesignal in ein n Bit umfassendes Digitalsignal und in ein Fehlersignal umwandelt. Darüber hinaus weist die Vorrichtung zur Unterdrückung von Grenzzyklen einen Rückkopplungsblock auf, welcher ausgehend von dem Fehlersignal das Rückkopplungssignal erzeugt und dem Addierer zuführt.

Im Unterschied zu bisherigen Lösungen sind der Filterblock zur Rauschumformung (also der eigentliche Noise-Shaping-Filter) und der Rückkopplungsblock als separate funktionelle Einheiten ausgebildet. Der Rückkopplungsblock hat dabei die Aufgabe, das Rückkopplungssignal zu erzeugen, welches zur Beseitigung der Grenzzyklen dient. Durch Addition dieses Rückkopplungssignals zum Ergebnissignal des Noise-Shaping-Filters lassen sich die von den Grenzzyklen verursachten Störsignale wirkungsvoll beseitigen; die Pfeifgeräusche auf dem Audiosignal verschwinden.

Bei der erfindungsgemäßen Lösung ist der Rückkopplungsblock dem Filterblock nachgeschaltet. Dadurch kann der Rückkopplungsblock zusammen mit beliebigen digitalen oder analogen Filterblöcken implementiert werden und ermöglicht so eine größere Freiheit beim Design von Noise-Shaping-Filtern, als dies bei bisherigen Lösungen möglich war.

Umgekehrt kann jeder bekannte Noise-Shaping-Filter nachträglich mit einer Einheit zur Unterdrückung von Grenzzyklen versehen werden, ohne dass das zugrundeliegende Filterdesign verändert werden müsste. Dazu ist es lediglich notwendig, den Addierer, den Rückkopplungsblock und eventuell die Teilerstufe entsprechend der erfindungsgemäßen Lösung anzupassen. Der separate Rückkopplungsblock lässt sich in Form einer einfachen Schaltungsanordnung realisieren und verursacht insofern nur geringen zusätzlichen Aufwand.

Es ist von Vorteil, wenn der Filterblock zur Rauschumformung als zwei- oder dreistufiges Noise-Shaping-Filter ausgebildet ist. Ein zwei- bis dreistufiges Noise-Shaping-Filter ermöglicht bei moderatem Implementierungsaufwand eine wirkungsvolle Umverteilung der Rauschintensität hin zu höheren Frequenzen. Aus diesem Grund verfügen die meisten Noise-Shaping-Filter über zwei oder drei Filterstufen.

Gemäß einer vorteilhaften Ausführungsform der Erfindung umfasst der Rückkopplungsblock einen Vorzeichenwandler zur Ermittlung des positiven Werts des Fehlersignals sowie ein Verzögerungsglied. Zur Eliminierung des Grenzzyklus ist es unverzichtbar, dass in einem ersten Schritt der positive Wert des Fehlersignals bestimmt wird. Dieser positive Wert des Fehlersignals wird im Verzögerungsglied gespeichert und liegt der weiteren Berechnung des Rückkopplungssignals zugrunde.

Es ist von Vorteil, wenn der Rückkopplungsblock einen Vorzeichenwandler zur Ermittlung des positiven Werts des Fehlersignals sowie ein Filterelement mit der Übertragungsfunktion $\frac{1}{z+\alpha}$ umfasst, wobei $\alpha = 2^{-s}$ und $s$ eine natürliche Zahl ist. Bei dieser Ausführungsform der Erfindung wird das einfache Verzögerungsglied durch ein Filterelement mit der Übertragungsfunktion $\frac{1}{z+\alpha}$ ersetzt. Ein derartiges Filterelement wirkt als modifiziertes Verzögerungsglied, bei dem der Ausgang abgeschwächt zum Eingang hin rückgekoppelt wird. Mit einem derartigen Filterelement lassen sich Grenzzyklen besser unterdrücken als mit einem einfachen Verzögerungsglied.

Gemäß einer ersten, digitalen Ausführungsform der Erfindung ist der Filterblock zur Rauschumformung ein Digitalfilter, und der Addierer, die Teilerstufe und der Rückkopplungsblock sind als digitale Signalverarbeitungsstufen realisiert. Bei dieser Ausführungsform der Erfindung wird die überabgetastete digitale Wertefolge komplett digital verarbeitet. Erst am Ende der digitalen Signalverarbeitungskette erfolgt eine Umwandlung des Digitalsignals in ein Analogsignal, und abgesehen von dem hierfür vorgesehenen Digital-/Analog-Wandler sind keine weiteren analogen Bausteine erforderlich. Auf diese Weise können die einzelnen Signalverarbeitungsstufen einfach und kostengünstig in Digitaltechnik realisiert werden.

Eine vollständig digitale Signalverarbeitung ist insbesondere in Hinblick auf die Implementierung der Teilerstufe von Vorteil, welche das Ausgabesignal des Addierers in ein n Bit umfassendes Digitalsignal und in ein Fehlersignal umwandelt. Zur Erzeugung des n Bit umfassenden Digitalsignals müssen lediglich die n höherwertigen Bits des (m + n) Bit umfassenden Ausgabesignals abgezweigt werden. Dabei ist es insbesondere von Vorteil, wenn die Teilerstufe das Fehlersignal als m Bit umfassendes digitales Fehlersignal zur Verfügung stellt. Dazu werden die verbleibenden niederwertigen m Bits des Ausgabesignals des Addierers verwendet. Die Teilerstufe führt also lediglich eine Aufteilung der Bitleitungen durch.

Es ist von Vorteil, wenn der Vorzeichenwandler den Betrag des Fehlersignals bestimmt. Dies kann beispielsweise durch Hinzufügen eines zusätzlichen höherwertigen Bits erfolgen, welches gleich Null gesetzt wird. Alternativ dazu ist es von Vorteil, wenn der Vorzeichenwandler des Rückkopplungsblocks das Zweierkomplement des Fehlersignals bestimmt.

Es ist von Vorteil, wenn das Filterelement mit der Übertragungsfunktion $\frac{1}{z+\alpha}$ mittels eines Verzögerungsglieds realisiert ist, wobei das um s Bitpositionen nach rechts verschobene Ausgabesignal des Verzögerungsglieds jeweils vom Eingangssignal des Verzögerungsglieds subtrahiert wird. Eine Rechtsverschiebung um s Bitpositionen lässt sich in der digitalen Signalverarbeitung sehr einfach mit Hilfe von Rechtsverschiebern realisieren.

Gemäß einer weiteren vorteilhaften Ausführungsform der Erfindung wird bei der Bestimmung des Rückkopplungssignals im Rückkopplungsblock mit einer um mindestens ein zusätzliches niederwertiges Bit erhöhten Genauigkeit gerechnet. Indem der relativ kleine Rückkopplungswert innerhalb des Rückkopplungsblocks mit erhöhter Präzision dargestellt wird, kann die Rechengenauigkeit innerhalb der Rückkopplungsschleife gesteigert werden. Dadurch können Grenzzyklen noch wirksamer unterdrückt werden, und zwar auch dann, wenn der Rückkopplungswert dann wieder mit normaler Genauigkeit (also ohne das zusätzliche niederwertige Bit) dargestellt wird.

Die Vorrichtung zur Unterdrückung von Grenzzyklen bei der Rauschumformung kann vorteilhaft mittels eines digitalen Signalprozessors realisiert werden. Dabei ist es insbesondere möglich, sowohl die Signalverarbeitungsschritte zur Realisierung des Noise-Shaping-Filters als auch die Rückkopplungsschleife komplett innerhalb des digitalen Signalprozessors zu programmieren. Daneben können noch weitere Signalverarbeitungsroutinen auf dem digitalen Signalprozessor abgelegt sein. Die Implementierung mittels digitaler Signalprozessoren stellt die gebräuchlichste Ausführungsform der Erfindung dar und lässt sich mit gängigen Signalprozessoren kostengünstig realisieren. Ein weiterer Vorteil beim Einsatz digitaler Signalprozessoren ist, dass sich die verschiedenen abgespeicherten Routinen flexibel umprogrammieren lassen.

Alternativ dazu ist es von Vorteil, wenn die Vorrichtung zur Unterdrückung von Grenzzyklen bei der Rauschumformung als Schaltungsanordnung in Hardware realisiert ist. Diese Ausführungsform erfordert, einen speziellen Chip bzw. einen speziellen funktionellen Block auf einem Chip für die Rauschumformung und die Rückkopplungsschleife vorzusehen. Dies bietet die Möglichkeit eines optimierten Signalflusses und ermöglicht bei speziellen Anforderungen eine bessere Performance als die entsprechende Lösung mit digitalen Signalprozessoren.

Es ist von Vorteil, wenn die Vorrichtung zur Umformung digitalisierter Audiosignale insbesondere in Mobilfunkempfängern verwendet wird. Empfangene überabgetastete Audiosignale können mittels des Noise-Shaping-Filters so umgeformt werden, dass sie einen guten Signal-Rausch-Abstand aufweisen. Mittels der erfindungsgemäßen Vorrichtung zur Unterdrückung unerwünschter Grenzzyklen ist es möglich, diese Audiosignale ohne störende Pfeifgeräusche hörbar zu machen.

Bisher war eine vollständig digitale Ausführungsform der Erfindung beschrieben worden. Das Konzept eines Noise-Shaping-Filters mit nachgeordneter Rückkopplungsschleife zur Unterdrückung von Grenzzyklen lässt sich aber einfach auf analoge Noise-Shaping-Filter übertragen.

Deshalb ist es von Vorteil, wenn der Filterblock zur Rauschumformung ein Analogfilter ist, und wenn der Addierer und der Rückkopplungsblock als analoge Signalverarbeitungsstufen realisiert sind. Die erfindungsgemäße Aufteilung der Filterstruktur in einen Filterblock und einen nachgeordneten Addierer sowie einen Rückkopplungsblock lässt sich also auf beliebige Analogfilter verallgemeinern. Der Anwendungsbereich der Erfindung ist daher nicht auf die digitale Signalverarbeitung beschränkt, sondern lässt sich auch in der analogen Signalverarbeitung nutzen.

Dabei ist es von Vorteil, wenn die Teilerstufe eine Mehrzahl von Komparatoren zur Erzeugung des n Bit umfassenden Digitalsignals aufweist. Hierbei wird das eingehende Analogsignal mit verschiedenen. Schwellwerten verglichen. Je nachdem, ob das Eingangssignal größer oder kleiner als das jeweilige Vergleichssignal ist, wird ein bestimmtes Bit des Digitalsignals gesetzt bzw. nicht gesetzt. Das von der Teilerstufe erzeugte Digitalsignal stellt das Ergebnissignal der ansonsten in Analogtechnik ausgeführten Rauschumformung dar. Dieses Digitalsignal lässt sich mittels eines Digital-/Analog-Wandlers in ein analoges Ergebnissignal umwandeln.

Dabei ist es von Vorteil, wenn das Fehlersignal als analoges Fehlersignal aus dem analogen Ausgabesignal des Addierers und dem in ein Analogsignal rückgewandelten, n Bit umfassenden Digitalsignal am Ausgang der Teilerstufe erhalten wird. Das analoge Fehlersignal dient als Ausgangspunkt für die Berechnung des Rückkopplungswerts. Das analoge Fehlersignal repräsentiert den Fehler, der bei der Umsetzung des analogen Ausgabesignals des Addierers in das von der Teilerstufe erzeugte, n Bit umfassende Digitalsignal auftritt. Wenn man das digitale Ausgabesignal der Teilerstufe in ein Analogsignal rückwandelt, dann liegen sowohl das Ausgabesignal des Addierers als auch das quantisierte Signal am Ausgang der Teilerstufe als Analogsignale vor. Das analoge Fehlersignal lässt sich dann durch Subtraktion von zwei Analogwerten erhalten.

Gemäß einer vorteilhaften Ausführungsform der Erfindung ist der Addierer mittels eines Operationsverstärkers realisiert. Dabei werden die zu addierenden Analogsignale den entsprechenden Eingängen des Operationsverstärkers zugeführt.

Um den positiven Wert des analogen Fehlersignals zu erhalten, ist es von Vorteil, den Vorzeichenwandler mittels eines Gleichrichters zu realisieren.

Gemäß einer vorteilhaften Ausführungsform der Erfindung sind die analogen Signalverarbeitungsstufen in Switched-Capacitor-Technik realisiert. Der Signalfluss wird hierbei mit Hilfe von elektrischen Ladungen verwirklicht, welche über getaktete Kapazitäten geführt werden. Bei der Switched-Capacitor-Technik handelt es sich um die derzeit gebräuchlichste Ausführungsform für integrierte Analogschaltungen.

Es ist von Vorteil, wenn die Vorrichtung für die digitale Aufzeichnung von Analogsignalen eingesetzt wird. Die analoge Ausführungsform der Erfindung kommt insbesondere dann zum Einsatz, wenn ein eingangs anliegendes Analogsignal einer Rauschumformung unterworfen werden soll. Hierbei wird das Analogsignal zunächst einem analogen Noise-Shaping-Filter zugeführt. Diesem Filter ist erfindungsgemäß ein Addierer sowie ein analoger Rückkopplungsblock nachgeschaltet, welcher die bei der Rauschumformung entstehenden unerwünschten Grenzzyklen unterdrückt. Dadurch kann die Qualität bei der digitalen Aufzeichnung von Analogsignalen verbessert werden.

Bei dem erfindungsgemäßen Verfahren zur Unterdrückung von Grenzzyklen bei der Rauschumformung wird in einem ersten Schritt das Eingangssignal mittels eines Filterblocks zur Rauschumformung gefiltert. Anschließend wird ein Rückkopplungssignal zu dem Ergebnissignal des Filterblocks zur Rauschumformung addiert. Im nächstfolgenden Schritt wird das Ausgabesignal der Addition in ein n Bit umfassendes Digitalsignal und in ein Fehlersignal umgewandelt. Ausgehend vom Fehlersignal kann dann im nächsten Schritt das Rückkopplungssignal erzeugt werden

Das erfindungsgemäße Verfahren zur Unterdrückung von Grenzzyklen bei der Rauschumformung lässt sich auf die Ergebnissignale von beliebigen Filterblocks zur Rauschumformung anwenden und ist unabhängig von der jeweiligen Implementierung des Filterblocks. Das erfindungsgemäße Verfahren zur Unterdrückung von Grenzzyklen bei der Rauschumformung lässt sich insofern auf die Ergebnissignale von beliebigen Filterblocks zur Rauschumformung anwenden und vereinfacht so das Design von Noise-Shaping-Filtern.

Nachfolgend.wird die Erfindung anhand von mehreren in der Zeichnung dargestellten Ausführungsbeispielen weiter beschrieben. Es zeigen:

Fig. 1A      eine erste Ausführungsform der Erfindung, bei der die verschiedenen Signalverarbeitungsstufen vollständig in digitaler Signalverarbeitungstechnik realisiert sind;

Fig. 1B      eine Ausschnittsvergrößerung des in digitaler Signalverarbeitungstechnik realisierten Rückkopplungsblocks;

Fig. 2A das Spektrum des Ausgabesignals am Noise-Shaping-Filter (durchgezogene Linie) bei konstantem Eingangssignal ohne den erfindungsgemäßen nichtlinearen Rückkopplungsblock für das in Fig. 1A gezeigte digitale Filter;

Fig. 2B das Spektrum des Ausgabesignals am Noise-Shaping-Filter (durchgezogene Linie) bei Verwendung des erfindungsgemäßen nichtlinearen Rückkopplungsblocks bei konstantem Eingangssignal für das in Fig. 1A gezeigte digitale Filter;

Fig. 3 eine zweite Ausführungsform der Erfindung, bei der der Filterblock, der Addierer sowie der Rückkopplungsblock in analoger Schaltungstechnik aufgebaut sind;

Fig. 4A das Spektrum des Ausgabesignals am Noise-Shaping-Filter (durchgezogene Linie) ohne den erfindungsgemäßen nichtlinearen Rückkopplungsblock für das in Fig. 3 gezeigte Analogfilter;

Fig. 4B das Spektrum des Ausgabesignals am Noise-Shaping-Filter (durchgezogene Linie) bei Verwendung des erfindungsgemäßen nichtlinearen Rückkopplungsblocks für das in Fig. 3 gezeigte Analogfilter.

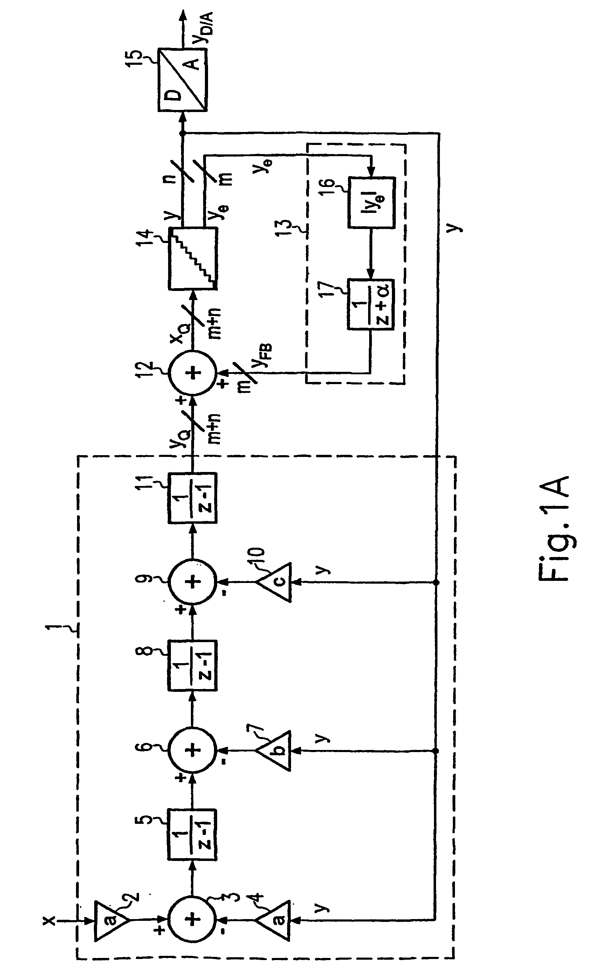

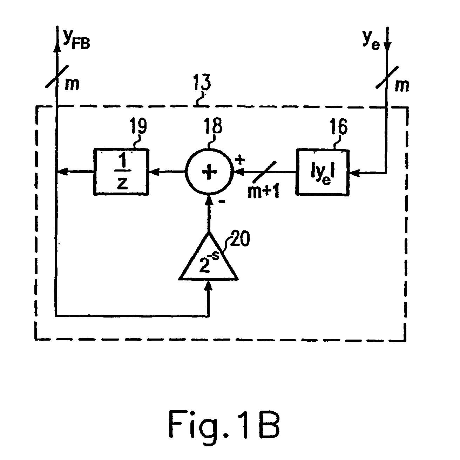

In den Fig. 1A und 1B ist ein erstes Ausführungsbeispiel der Erfindung gezeigt, bei dem die einzelnen Signalverarbeitungsstufen vollständig in Digitaltechnik realisiert sind. Das digitale Eingangssignal x, das in Fig. 1A links oben dargestellt ist, wird dem Filterblock 1 zur Rauschumformung zugeführt. Bei dem Eingangssignal x handelt es sich um ein überabgetastetes digitales Eingangssignal, welches aus einer Folge von beispielsweise 23 Bit breiten Datenwörtern besteht. Bei dem Eingangssignal kann es sich um ein überabgetastetes Audiosignal handeln, wobei die Abtastrate beispielsweise 4 MHz betragen kann. Dem eigentlichen Nutzsignal ist ein Quantisierungsgeräusch überlagert, das eine gleichmäßige spektrale Verteilung aufweist (weißes Rauschen).

Bei dem Filterblock 1 handelt es sich um ein Noise-Shaping-Filter dritter Ordnung, welches drei hintereinandergeschaltete Filterstufen aufweist. Dem Filterblock 1 wird neben dem Eingangssignal x auch das am Ausgang der Schaltungsanordnung erscheinende Digitalsignal y zugeführt, das die n höchstwertigen Bits ("Most Significant Bits") des Ausgabesignals umfasst.

Das Eingangssignal x wird durch den Multiplizierer 2 mit dem Filterkoeffizienten a multipliziert und dem Addierer 3 zugeführt. Im Multiplizierer 4 wird das rückgeführte Signal y mit dem Filterkoeffizienten a multipliziert; das resultierende Signal a.y wird dem Addierer 3 mit negativem Vorzeichen zugeführt. Der Ausgang des Addierers 3 ist mit dem Integrator 5 verbunden, der sich mittels der Übertragungsfunktion

$$\frac{1}{z\text{-}1}$$

beschreiben lässt. Der Addierer 3, die beiden Multiplizierer 2 und 4 sowie der Integrator 5 bilden zusammen die erste Filterstufe des dreistufigen Noise-Shaping-Filters.

Die zweite Filterstufe umfasst den Addierer 6, den Multiplizierer 7 sowie den Integrator 8. Dem Addierer 6 wird das Ausgabesignal des Integrators 5 mit positivem Vorzeichen zugeführt. Daneben wird dem Addierer 6 das mit dem Filterkoeffizienten b multiplizierte rückgeführte Signal y mit negativem Vorzeichen zugeführt. Der Ausgang des Addierers 6 ist mit dem Integrator 8 verbunden.

Die dritte Filterstufe umfasst den Addierer 9, den Multiplizierer 10 und den Integrator 11. Im Addierer 9 wird das mit dem Filterkoeffizienten c multiplizierte Signal y vom Ausgabesignal des Integrators 8 subtrahiert; das Ergebnis der Subtraktion wird dem Integrator 11 zugeführt.

Am Ausgang des Integrators 11 kann das Ergebnissignal $y_Q$ des Filterblocks abgegriffen werden. Das Signal $y_Q$ liegt als Datenwort der Bitbreite m+n vor, wobei beispielsweise m = 7 und n = 5 gewählt werden kann. Im Addierer 12 wird zu dem Ergebnissignal $y_Q$ das m Bit breite Rückkopplungssignal $y_{FB}$ addiert, das vom Rückkopplungsblock 13 erzeugt wird. Am Ausgang des Addierers 12 erscheint das Signal $x_Q$, wobei $x_Q = y_Q + y_{FB}$ gilt. Das m+n Bit umfassende Ausgabesignal $x_Q$ wird dem Teiler 14 zugeführt, der das Signal $x_Q$ in das Digitalsignal y und in das Fehlersignal $y_e$ aufspaltet, wobei das Digitalsignal y die höherwertigen n Bit des Signals $x_Q$ und das Fehlersignal $y_e$ die niederwertigen m Bit des Signals $x_Q$ umfasst.

Das Digitalsignal y wird zum einen zum Filterblock 1 rückgekoppelt und zum anderen dem Digital-/Analog-Wandler 15 zugeführt, der das Digitalsignal y in das Analogsignal $y_{D/A}$ umwandelt.

Mit Hilfe des Filterblocks 1 zur Rauschumformung wird das anfangs gleichverteilte Quantisierungsrauschen zu höheren Frequenzen hin verlagert. Insofern weist auch das analoge Ergebnissignal $y_{D/A}$ keine gleichverteilte Rauschintensität mehr auf; statt dessen ist bei höheren Frequenzen überproportional viel Rauschintensität vorhanden. Durch eine Tiefpaßfilterung des Signals $y_{D/A}$ kann daher ein Großteil der Rauschintensität beseitigt werden.

Das Fehlersignal $y_e$, das die niederwertigen m Bit des Signals $x_Q$ umfasst, dient als Ausgangspunkt zur Berechnung des Rückkopplungssignals $y_{FB}$. Hierzu

wird das Fehlersignal $y_e$ dem Rückkopplungsblock 13 zugeführt, der den Vorzeichenwandler 16 sowie das Filterelement 17 umfasst. Der Vorzeichenwandler 16 bestimmt den positiven Wert des Fehlersignals $y_e$. Dies kann dadurch erfolgen, dass der Betrag $|y_e|$ des Fehlersignals $y_e$ gebildet wird. Dazu ist es beispielsweise möglich, das m Bit umfassende Bitmuster des Signals $y_e$ um ein höchstwertiges Vorzeichenbit zu ergänzen, welches gleich Null gesetzt wird. Alternativ dazu ist es möglich, das Zweierkomplement des Fehlersignals $y_e$ zu bestimmen. Je nach verwendetem Zahlenformat kann hierzu beispielsweise das m Bit umfassende Bitmuster des Fehlersignals um ein zusätzliches, niederwertiges Bit ergänzt werden.

Der positive Wert des Fehlersignals $y_e$ wird dem Filterelement 17 zugeführt, dessen Übertragungsfunktion sich darstellen lässt als

$$\frac{1}{z-\alpha}$$

wobei $\alpha = 2^{-s}$ ist, und wobei s eine natürliche Zahl ist. Am Ausgang des Filterelements 17 kann das Rückkopplungssignal $y_{FB}$ abgegriffen werden, welches dem Addierer 12 zugeführt wird.

In Fig. 1B ist der Rückkopplungsblock 13 noch einmal in einer detaillierteren Darstellung gezeigt. Das m Bit umfassende Fehlersignal $y_e$ wird dem Vorzeichenwandler 16 zugeführt. Im Vorzeichenwandler 16 wird der Betrag bzw. das Zweierkomplement des Fehlersignals $y_e$ gebildet. Am Ausgang des Vorzeichenwandlers 16 liegt der positive Wert des Fehlersignals als (m+1) Bit breites Signal an; dieses Signal ist mit einem Eingang des Addierers 18 verbunden. Der jeweilige Ausgang des Addierers 18 wird im Verzögerungsglied 19 abgespeichert, an dessen Ausgang das Rückkopplungssignal $y_{FB}$ abgegriffen werden kann.

Das am Ausgang des Verzögerungsglieds 19 anliegende Signal wird darüber hinaus dem Rechtsverschieber 20 zugeführt, der eine Rechtsverschiebung des anliegenden Bitmusters um s Bitpositionen durchführt. Dies entspricht einer Multiplikation des Rückkopplungssignals $y_{FB}$ mit dem Faktor $2^{-s}$. Empirisch wurde ermittelt, dass Werte von s = 6 und s = 7 gute Ergebnisse liefern. Das um s Bitpositionen nach rechts verschobene Bitmuster liegt mit negativem Vorzeichen am zweiten Eingang des Addierers 18 an. Bei dem Addierer 18 handelt es sich vorzugsweise um einen gesättigten Addierer.

Von dem positiven Fehlersignal wird somit jeweils der mit dem Faktor $2^{-s}$ gewichtete Vorgängerwert des Rückkopplungssignals $y_{FB}$ abgezogen, um so den aktuellen Wert des Rückkopplungssignals $y_{FB}$ zu erhalten. Es gilt also jeweils:

$$y_{FB}(t) = |y_e(t-1)| - 2^{-s} \cdot y_{FB}(t-1)$$

wobei $y_{FB}(t-1)$ den Vorgängerwert und $y_{FB}(t)$ den aktuellen Wert des Rückkopplungssignals bezeichnet. Bei der Durchführung dieser Berechnung ist es von Vorteil, wenn innerhalb des Rückkopplungsblocks 13, also im Addierer 18, im Verzögerungsglied 19 sowie im Rechtsverschieber 20 mit einer um mindestens ein niederwertiges Bit erweiterten Genauigkeit gerechnet wird. Dies bedeutet, dass in diesen Blöcken mit wenigstens (m+1) Bits gerechnet wird. Dieses zusätzliche niederwertige Bit bleibt allerdings beim Rückkopplungssignal $y_{FB}$ unberücksichtigt. Darüber hinaus sind im gesamten Rückkopplungsbereich die jeweils benötigten höchstwertigen Bits ("Most Significant Bits") dergestalt vorgesehen, dass kein Überlauf auftritt.

Der Addierer 18, das Verzögerungsglied 19 sowie der Rechtsverschieber 20 entsprechen in ihrem Zusammenwirken einem Filterelement mit der Übertragungsfunktion

$$\frac{1}{z+\alpha}$$, wobei $\alpha = 2^{-s}$ und s eine natürliche Zahl ist.

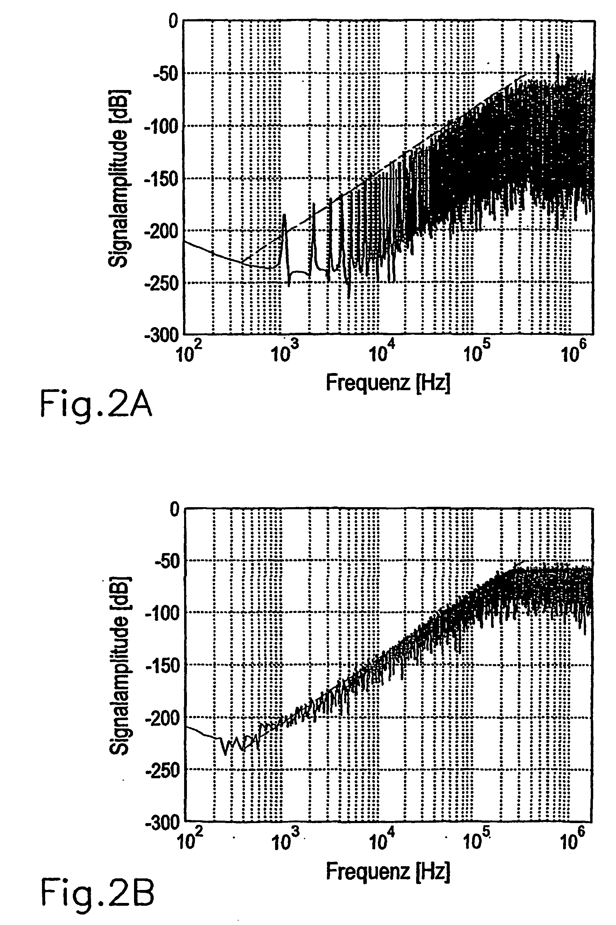

In Fig. 2A ist das Spektrum des Ausgabesignals y des Noise-Shaping-Filters ohne den nichtlinearen Rückkopplungsblock dargestellt, wobei das Eingangssignal x jeweils konstant gehalten wird. Nach rechts ist die Frequenz in Hertz, nach oben die Signalamplitude in Dezibel aufgetragen. Das entsprechende Spektrum wurde in Fig. 2B noch einmal unter Verwendung des Rückkopplungsblocks 13 aufgezeichnet. Wieder ist das Spektrum des Ausgabesignals y am Noise-Shaping-Filter bei konstantem Eingangssignal x als durchgezogene Linie dargestellt. Darüber hinaus ist der Trendverlauf des Spektrums als gestrichelte Linie eingezeichnet.

Durch Vergleich der in den Fig. 2A und 2B gezeigten Spektren erkennt man, dass die dem eigentlichen Spektrum in Fig. 2A überlagerten harmonischen Komponenten mit Hilfe des Rückkopplungsblocks 13 wirksam unterdrückt werden können. Offensichtlich vermag also der nichtlineare Rückkopplungsblock die im Filterblock 1 entstehenden Grenzzyklen zu eliminieren.

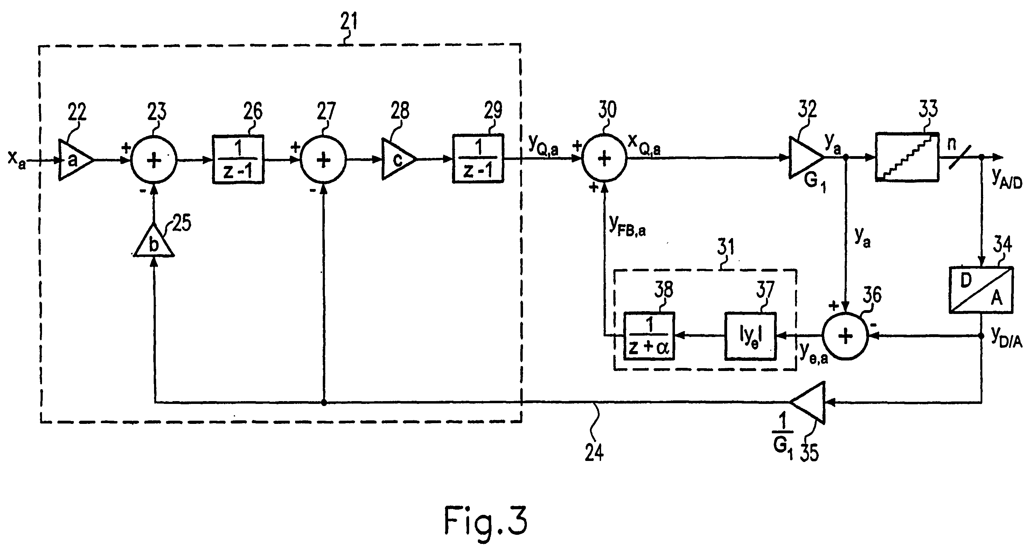

In Fig. 3 ist eine alternative Ausführungsform der Erfindung dargestellt, die zum überwiegenden Teil in analoger Schaltungstechnik aufgebaut ist. Das analoge Eingangssignal $x_a$ liegt am Eingang des analogen Filterblocks 21 an, der als zweistufiger Noise-Shaping-Filter aufgebaut ist. Das Eingangssignal $x_a$ wird durch den analogen Multiplizierer 22 mit dem Filterkoeffizienten a multipliziert und liegt mit positivem Vorzeichen am ersten Eingang des analogen Addierers 23 an. Das rückgeführte Ergebnissignal 24 wird im analogen Multiplizierer 25 mit dem Filterkoeffizienten b multipliziert und liegt mit negativem Vorzeichen am zweiten Eingang des Addierers 23 an.

Der analoge Addierer 23 kann vorteilhafterweise als Operationsverstärker ausgeführt sein.

Das Ausgabesignal des Addierers 23 wird dem Integrator 26 zugeführt, dessen Ausgang mit dem Eingang des Addierers 27 verbunden ist. Am zweiten Eingang des Addierers 27 liegt das rückgeführte Ergebnissignal 24 mit negativem Vorzeichen an. Der Multiplizierer 28 multipliziert das Ausgabesignal des Addierers 27 mit dem Filterkoeffizienten c, und das Ausgabesignal des Multiplizierers 28 wird im Integrator 29 aufintegriert. Am Ausgang des Integrators 29 kann das analoge Ergebnissignal $y_{Q,a}$ des Filterblocks 21 abgegriffen werden.

Im Addierer 30 wird das analoge Rückkopplungssignal $y_{FB,a}$ zu dem Signal $y_{Q,a}$ addiert, um so das analoge Signal $x_{Q,a}$ zu erhalten. Dieses Signal $x_{Q,a}$ wird im Verstärkungsglied 32 mit dem Verstärkungsfaktor $G_1$ multipliziert, um das analoge Signal $y_a$ zu erhalten. In der Teilerstufe 33 wird das analoge Signal $y_a$ in ein n Bit umfassendes Digitalsignal $y_{A/D}$ umgewandelt, wobei beispielsweise n = 4 gewählt werden kann. Die Teilerstufe 33 ist mittels einer Vielzahl von Komparatoren aufgebaut, die jeweils einen Vergleich des analogen Eingangssignals $y_a$ mit verschiedenen Schwellwerten vornehmen. In Abhängigkeit von den Ergebnissen dieser Vergleichsoperationen werden die n Bitleitungen, die das Digitalsignal $y_{A/D}$ repräsentieren, auf "Null" oder "Eins" gesetzt.

Als Ausgangspunkt zur Berechnung des analogen Rückkopplungssignals $y_{FB,a}$ wird das analoge Fehlersignal $y_{e,a}$ benötigt, das den bei der Analog-/Digital-Wandlung auftretenden Quantisierungsfehler repräsentiert. Dieses Fehlersignal $y_{e,a}$ wird als Differenz des analogen Signals $y_a$ und des n Bit umfassenden Digitalsignals $y_{A/D}$ erhalten. Hierzu muss das Digitalsignal $y_{A/D}$ aber zuerst in das Analogsignal $y_{D/A}$ rückverwandelt werden. Dies geschieht mit Hilfe des Digital-/Analog-Wandlers 34, an dessen Ausgang das Analogsignal $y_{D/A}$ anliegt. Dieses Signal wird im Multiplizierer 35 mit dem Skalierungsfaktor $\frac{1}{G_1}$ multipliziert, um das rückgeführte Ergebnissignal 24 zu erhalten. Außerdem wird das Analogsignal $y_{D/A}$ dem analogen Addierer 36 mit negativem Vorzeichen zugeführt. Der Addierer 36 berechnet das analoge Fehlersignal $y_{e,a}$ als Differenz der Analogsignale $y_a$ und $y_{D/A}$. Es gilt also $y_{e,a} = y_a - y_{D/A}$.

Das analoge Fehlersignal $y_{e,a}$ wird durch den analogen Rückkopplungsblock 31 in das analoge Rückkopplungssignal $y_{FB,a}$ umgewandelt. Hierzu wird zunächst durch den Vorzeichenwandler 37 der Absolutbetrag $|y_{e,a}|$ des Fehlersignals $y_{e,a}$ gebildet. Der Vorzeichenwandler 37 kann als analoger Gleichrichter ausgeführt sein. Das Signal $|y_{e,a}|$ wird anschließend durch das Filterelement 38 mit der Filterfunktion $\frac{1}{z+\alpha}$ gefiltert. Die Filterfunktion $\frac{1}{z+\alpha}$ ist in der z-Ebene dargestellt, wobei der Filterparameter $\alpha$ z.B. als $\alpha = 2^{-6}$ gewählt werden kann. Am Ausgang des Filterelements 38 liegt das Rückkopplungssignal $y_{FB,a}$ des analogen Rückkopplungsblocks 31, das dann zum Signal $y_{Q,a}$ addiert werden kann.

Der nichtlineare Rückkopplungsblock wird in eine vorgegebene Noise-Shaper-Struktur in Hardware eingefügt. Dabei bietet es sich an, die analogen Signalverarbeitungsstufen in Switched-Capacitor-Schaltungstechnik zu realisieren.

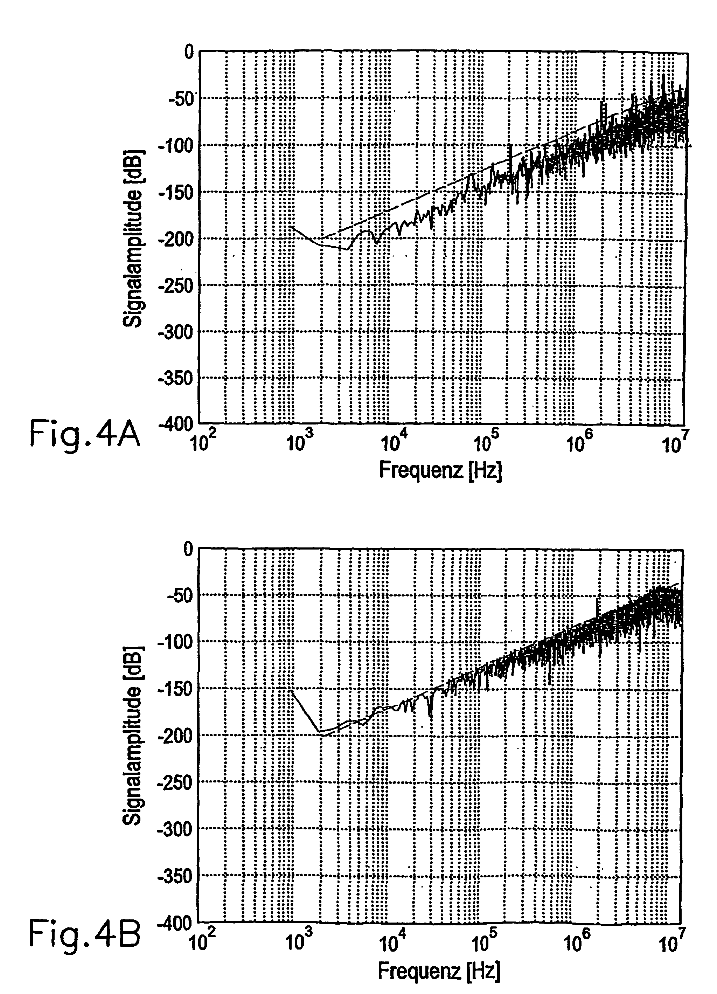

Bei dem n Bit umfassenden Digitalsignal $y_{A/D}$ handelt es sich um das Ergebnissignal der Filterschaltung. Anhand der Fig. 4A und 4B soll gezeigt werden, dass sich mit Hilfe des analogen Rückkopplungsblocks 31 Grenzzyklen und harmonische Komponenten wirkungsvoll unterdrücken lassen.

In Fig. 4A ist das Spektrum des Ausgabesignals y des Noise-Shaping-Filters ohne den nichtlinearen Filterblock als durchgezogene Linie dargestellt. Als Eingangssignal $x_a$ wurde ein konstantes Signal mit einem überlagerten Sinussignal der Frequenz 2 MHz verwendet. Nach rechts ist die Frequenz in Hertz, nach oben die Signalamplitude in Dezibel aufgetragen.

Dagegen ist in Fig. 4B das Spektrum des Ergebnissignals $y_a$ bei Verwendung des erfindungsgemäßen analogen Rückkopplungsblocks aufgetragen. Wieder wurde als Eingangssignal $x_a$ ein konstantes Signal mit überlagertem Sinussignal der Frequenz 2 MHz verwendet. Der Trendverlauf des Spektrums ist in Fig. 4B als gestrichelte Linie eingezeichnet. Insbesondere bei höheren Frequenzen im Bereich zwischen $10^5$ und $10^7$ Hz ist eine deutliche Abnahme der durch Grenzzyklen verursachten harmonischen Störungen zu erkennen.

**Patentansprüche**

1. Vorrichtung zur Unterdrückung von Grenzzyklen bei der Rauschumformung, welche aufweist

   - einen Filterblock (1, 21) zur Rauschumformung,
   - einen Addierer (12, 30), an dessen erstem Eingang das Ergebnissignal ($y_Q$, $y_{Q,a}$) des Filterblocks zur Rauschumformung anliegt, an dessen zweitem Eingang ein Rückkopplungssignal ($y_{FB}$, $y_{FB,a}$) anliegt, und dessen Ausgabesignal ($x_Q$, $x_{Q,a}$) einer Teilerstufe (14, 33) zugeführt wird,
   - eine Teilerstufe (14, 33), die das Ausgabesignal ($x_Q$, $x_{Q,a}$) des Addierers in ein n Bit umfassendes Digitalsignal (y, $y_{A/D}$) und in ein Fehlersignal ($y_e$, $y_{e,a}$) umwandelt, sowie
   - einen Rückkopplungsblock (13, 31), welcher ausgehend von dem Fehlersignal ($y_e$, $y_{e,a}$) das Rückkopplungssignal ($y_{FB}$, $y_{FB,a}$) erzeugt und dem Addierer (12, 30) zuführt.

2. Vorrichtung nach Anspruch 1,
   **dadurch gekennzeichnet, dass**
   der Filterblock (1, 21) zur Rauschumformung als zwei- oder dreistufiges Noise-Shaping-Filter ausgebildet ist.

3. Vorrichtung nach Anspruch 1 oder Anspruch 2,
   **dadurch gekennzeichnet, dass**
   der Rückkopplungsblock (13, 31) einen Vorzeichenwandler (16, 37) zur Ermittlung des positiven Werts des Fehlersignals (y$_e$, y$_{e,a}$) sowie ein Verzögerungsglied (19) umfasst.

4. Vorrichtung nach einem der vorhergehenden Ansprüche,
**dadurch gekennzeichnet, dass**
der Rückkopplungsblock (13, 31) einen Vorzeichenwandler (16, 37) zur Ermittlung des positiven Werts des Fehlersignals (y$_e$, y$_{e,a}$) sowie ein Filterelement (17, 38) mit der Übertragungsfunktion $\frac{1}{z + \alpha}$ umfasst, wobei $\alpha = 2^{-s}$ und s eine natürliche Zahl ist.

5. Vorrichtung nach einem der vorhergehenden Ansprüche,
**dadurch gekennzeichnet, dass**
der Filterblock (1) zur Rauschumformung ein Digitalfilter ist und dass der Addierer (12), die Teilerstufe (14) und der Rückkopplungsblock (13) als digitale Signalverarbeitungsstufen realisiert sind.

6. Vorrichtung nach Anspruch 5,
**dadurch gekennzeichnet, dass**
die Teilerstufe (14) das Fehlersignal (y$_e$) als m Bit umfassendes digitales Fehlersignal zur Verfügung stellt.

7. Vorrichtung nach Anspruch 5 oder Anspruch 6,
**dadurch gekennzeichnet, dass**
der Vorzeichenwandler (16) des Rückkopplungsblocks (13) den Betrag des Fehlersignals (y$_e$) bestimmt.

8. Vorrichtung nach Anspruch 5 oder Anspruch 6,
**dadurch gekennzeichnet, dass**
der Vorzeichenwandler (16) des Rückkopplungsblocks (13) das Zweierkomplement des Fehlersignals (y$_e$) bestimmt.

9. Vorrichtung nach einem der Ansprüche 5 bis 8,
**dadurch gekennzeichnet, dass**
das Filterelement (17) mit der Übertragungsfunktion $\frac{1}{z + \alpha}$ mittels eines Verzögerungsglieds (19) realisiert ist, wobei $\alpha = 2^{-s}$, wobei s eine natürliche Zahl ist, und wobei das um s Bitpositionen nach rechts verschobene Ausgabesignal des Verzögerungsglieds (19) jeweils vom Eingangssignal des Verzögerungsglieds subtrahiert wird.

10. Vorrichtung nach einem der Ansprüche 5 bis 9,
**dadurch gekennzeichnet, dass**
bei der Bestimmung des Rückkopplungssignals (y$_{FB}$) im Rückkopplungsblock (13) mit einer um mindestens ein zusätzliches niederwertiges Bit erhöhten Genauigkeit gerechnet wird.

11. Vorrichtung nach einem der Ansprüche 5 bis 10,
**dadurch gekennzeichnet, dass**

die Vorrichtung mittels eines digitalen Signalprozessors realisiert ist.

12. Vorrichtung nach einem der Ansprüche 5 bis 10,
**dadurch gekennzeichnet, dass**
die Vorrichtung als Schaltungsanordnung in Hardware realisiert ist.

13. Vorrichtung nach einem der Ansprüche 5 bis 12,
**dadurch gekennzeichnet, dass**
die Vorrichtung zur Umformung digitalisierter Audiosignale, insbesondere in Mobilfunkempfängern verwendet wird.

14. Vorrichtung nach einem der Ansprüche 1 bis 4,
**dadurch gekennzeichnet, dass**
der Filterblock (21) zur Rauschumformung ein Analogfilter ist, und dass der Addierer (30) und der Rückkopplungsblock (31) als analoge Signalverarbeitungsstufen realisiert sind.

15. Vorrichtung nach Anspruch 14,
**dadurch gekennzeichnet, dass**
die Teilerstufe (33) einen eingangs angeordneten Analog/Digital-Wandler zur Erzeugung des n Bit umfassenden Digitalsignals (y$_{A/D}$) umfasst.

16. Vorrichtung nach Anspruch 14 oder Anspruch 15,
**dadurch gekennzeichnet, dass**
das Fehlersignal (y$_{e,a}$) als analoges Fehlersignal aus dem analogen Ausgabesignal (x$_{Q,a}$) des Addierers (30) und dem in ein Analogsignal (y$_{D/A}$) rückgewandelten n Bit umfassenden Digitalsignal (y$_{A/D}$) der Teilerstufe (33) erhalten wird.

17. Vorrichtung nach einem der Ansprüche 14 bis 16,
**dadurch gekennzeichnet, dass**
der Addierer (30) mittels eines Operationsverstärkers realisiert ist.

18. Vorrichtung nach einem der Ansprüche 14 bis 17,
**dadurch gekennzeichnet, dass**
der Vorzeichenwandler (37) mittels eines Gleichrichters realisiert ist.

19. Vorrichtung nach einem der Ansprüche 14 bis 18,
**dadurch gekennzeichnet, dass**
die analogen Signalverarbeitungsstufen in Switched-Capacitor-Technik realisiert sind.

20. Vorrichtung nach einem der Ansprüche 14 bis 19,
**dadurch gekennzeichnet, dass**
die Vorrichtung für die digitale Aufzeichnung von Analogsignalen eingesetzt wird.

21. Verfahren zur Unterdrückung von Grenzzyklen bei der Rauschumformung, **gekennzeichnet durch** folgende Schritte:

a) Filtern des Eingangssignals (x, $x_a$) mittels eines Filterblocks (1, 21) zur Rauschumformung;
b) Addieren eines Rückkopplungssignals ($y_{FB}$, $y_{FB,a}$) zu dem Ergebnissignal ($y_Q$, $y_{Q,a}$) des Filterblocks (1, 21) zur Rauschumformung;
c) Umwandeln des Ausgabesignals ($x_Q$, $x_{Q,a}$) der Addition in ein n Bit umfassendes Digitalsignal (y, $y_{A/D}$) und in ein Fehlersignal ($y_e$, $y_{e,a}$);
d) ausgehend vom Fehlersignal ($y_e$, $y_{e,a}$), Erzeugen des Rückkopplungssignals ($y_{FB}$, $y_{FB,a}$).

**22.** Verfahren nach Anspruch 21,
**dadurch gekennzeichnet, dass**
zur Erzeugung des Rückkopplungssignals ($y_{FB}$, $y_{FB,a}$) der positive Wert des Fehlersignals ($y_e$, $y_{e,a}$) bestimmt und in einem Verzögerungsglied (19) abgespeichert wird.

**23.** Verfahren nach Anspruch 21 oder Anspruch 22,
**dadurch gekennzeichnet, dass**
zur Erzeugung des Rückkopplungssignals ($y_{FB}$, $y_{FB,a}$) der positive Wert des Fehlersignals ($y_e$, $y_{e,a}$) bestimmt und mit einem Filterelement (17, 38) der Filtercharakteristik $\frac{1}{z+\alpha}$ gefiltert wird, wobei $\alpha = 2^{-s}$ und s eine natürliche Zahl ist.

**24.** Verfahren nach einem der Ansprüche 21 bis 23,
**dadurch gekennzeichnet, dass**
die Schritte a) bis d) in Form von digitalen Verarbeitungsstufen ausgebildet sind.

**25.** Verfahren nach Anspruch 24,
**dadurch gekennzeichnet, dass**
das Ausgabesignal ($x_Q$) der Addition in ein n Bit umfassendes Digitalsignal (y) und in ein m Bit umfassendes digitales Fehlersignal ($y_e$) umgewandelt wird.

**26.** Verfahren nach Anspruch 24 oder Anspruch 25,
**dadurch gekennzeichnet, dass**
zur Erzeugung des Rückkopplungssignals ($y_{FB}$) der positive Wert des Fehlersignals ($y_e$) bestimmt und mit einem Filterelement (17) der Filtercharakteristik $\frac{1}{z+\alpha}$ gefiltert wird, welches mittels eines Verzögerungsglieds (19) realisiert ist, wobei $\alpha = 2^{-s}$, wobei s eine natürliche Zahl ist, und wobei das um s Bitpositionen nach rechts verschobene Ausgabesignal des Verzögerungsglieds jeweils vom Eingangssignal des Verzögerungsglieds subtrahiert wird.

**27.** Verfahren nach einem der Ansprüche 21 bis 23,
**dadurch gekennzeichnet, dass**
die Schritte a), b) und d) als analoge Verarbeitungsstufen ausgebildet sind.

**28.** Verfahren nach Anspruch 27,
**dadurch gekennzeichnet, dass**

zum Umwandeln des Ausgabesignals ($x_{Q,a}$) der Addition in ein n Bit umfassendes Digitalsignal ($y_{A/D}$) eine Analog-/Digital-Wandlung des Ausgabesignals ($x_{Q,a}$) der Addition durchgeführt wird.

**29.** Verfahren nach Anspruch 27 oder Anspruch 28,
**dadurch gekennzeichnet, dass**
das Fehlersignal ($y_{e,a}$) als analoges Fehlersignal aus dem analogen Ausgabesignal ($x_{Q,a}$) der Addition und dem in ein Analogsignal ($y_{D/A}$) rückverwandelten, n Bit umfassenden Digitalsignal ($y_{A/D}$) erhalten wird.

**Claims**

**1.** Apparatus for suppressing limit cycles during noise conversion, which has

- a filter block (1, 21) for noise conversion,
- an adder (12, 30) at whose first input the result signal ($y_Q$, $Y_{Q,a}$) of the filter block for noise conversion is present, at whose second input a feedback signal ($y_{FB}$, $y_{FB,a}$) is present, and whose output signal ($x_Q$, $x_{Q,a}$) is fed to a divider stage (14, 33),
- a divider stage (14, 33) that converts the output signal ($x_Q$, $x_{Q,a}$) of the adder into a digital signal (y, $y_{A/D}$) comprising n bits and into an error signal ($y_e$, $y_{e,a}$), and
- a feedback block (13, 31) that generates the feedback signal ($y_{FB}$, $y_{FB,a}$), starting from the error signal ($y_e$, $y_{e,a}$), and feeds it to the adder (12, 30).

**2.** Apparatus according to Claim 1, **characterized in that** the filter block (1, 21) for noise conversion is designed as a two- or three-stage noise shaping filter.

**3.** Apparatus according to Claim 1 or Claim 2, **characterized in that** the feedback block (13, 31) comprises a sign converter (16, 37) for determining the positive value of the error signal ($y_e$, $y_{e,a}$) and a time delay element (19).

**4.** Apparatus according to one of the preceding claims, **characterized in that** the feedback block (13, 31) comprises a sign converter (16, 37) for determining the positive value of the error signal ($y_e$, $y_{e,a}$) and a filter element (17, 38) having the transfer function $\frac{1}{z+\alpha}$, where $\alpha = 2^{-s}$, and s is a natural number.

**5.** Apparatus according to one of the preceding claims, **characterized in that** the filter block (1) for noise conversion is a digital filter, and **in that** the adder (12), the divider stage (14) and the feedback block (13) are implemented as digital signal processing stages.

6. Apparatus according to Claim 5, **characterized in that** the divider stage (14) makes the error signal ($y_e$) available as a digital error signal comprising m bits.

7. Apparatus according to Claim 5 or Claim 6, **characterized in that** the sign converter (16) of the feedback block (13) determines the magnitude of the error signal ($y_e$).

8. Apparatus according to Claim 5 or Claim 6, **characterized in that** the sign converter (16) of the feedback block (13) determines the two's complement of the error signal ($y_e$).

9. Apparatus according to one of Claims 5 to 8, **characterized in that** the filter element (17) with the transfer function $\frac{1}{z+\alpha}$ is implemented by means of a time delay element (19), where $\alpha = 2^{-s}$, s being a natural number, and the output signal, shifted to the right by s bit positions, of the time delay element (19), being subtracted in each case from the input signal of the time delay element.

10. Apparatus according to one of Claims 5 to 9, **characterized in that** when the feedback signal ($y_{FB}$) is being determined in the feedback block (13) the calculation is performed with an accuracy increased by at least one additional less significant bit.

11. Apparatus according to one of Claims 5 to 10, **characterized in that** the apparatus is implemented by means of a digital signal processor.

12. Apparatus according to one of Claims 5 to 10, **characterized in that** the apparatus is implemented as a hardware circuit arrangement.

13. Apparatus according to one of Claims 5 to 12, **characterized in that** the apparatus is used for converting digitized audio signals, in particular in mobile radio receivers.

14. Apparatus according to one of Claims 1 to 4, **characterized in that** the filter block (21) for noise conversion is an analogue filter, and **in that** the adder (30) and the feedback block (31) are implemented as analogue signal processing stages.

15. Apparatus according to Claim 14, **characterized in that** the divider stage (33) comprises an analogue/digital converter, arranged at the start, for generating the digital signal ($y_{A/D}$) comprising n bits.

16. Apparatus according to Claim 14 or Claim 15, **char-**

**acterized in that** the error signal ($y_{e,a}$) is obtained as an analogue error signal from the analogue output signal ($x_{Q,a}$) of the adder (30) and the digital signal ($y_{A/D}$), back-converted into an analogue signal ($y_{D/A}$) and comprising n bits, of the divider stage (33).

17. Apparatus according to one of Claims 14 to 16, **characterized in that** the adder (30) is implemented by means of an operational amplifier.

18. Apparatus according to one of Claims 14 to 17, **characterized in that** the sign converter (37) is implemented by means of a rectifier.

19. Apparatus according to one of Claims 14 to 18, **characterized in that** the analogue signal processing stages are implemented using switched capacitor technology.

20. Apparatus according to one of Claims 14 to 19, **characterized in that** the apparatus is used for digital recording of analogue signals.

21. Method for suppressing limit cycles during noise conversion, **characterized by** the following steps:

a) filtering the input signal ($x$, $x_a$) by means of a filter block (1, 21) for noise conversion;
b) adding a feedback signal ($y_{FB}$, $y_{FB,a}$) to the result signal ($y_Q$, $y_{Q,a}$) of the filter block (1, 21) for noise conversion;
c) converting the output signal ($x_Q$, $x_{Q,a}$) of the addition into a digital signal ($y$, $y_{A/D}$) comprising n bits and into an error signal ($y_e$, $y_{e,a}$);
d) generating the feedback signal ($y_{FB}$, $y_{FB,a}$) starting from the error signal ($y_e$, $y_{e,a}$).

22. Method according to Claim 21, **characterized in that** in order to generate the feedback signal ($y_{FB}$, $y_{FB,a}$) the positive value of the error signal ($y_e$, $y_{e,a}$) is determined and is stored in a time delay element (19).

23. Method according to Claim 21 or Claim 22, **characterized in that** in order to generate the feedback signal ($y_{FB}$, $y_{FB,a}$) the positive value of the error signal ($y_e$, $y_{e,a}$) is determined and filtered with the aid of a filter element (17, 38) of the filter characteristic $\frac{1}{z+\alpha}$, where $\alpha = 2^{-s}$, and s is a natural number.

24. Method according to one of Claims 21 to 23, **characterized in that** steps a) to d) are designed in the form of digital processing stages.

25. Method according to Claim 24, **characterized in that** the output signal ($x_Q$) of the addition is converted into a digital signal ($y$) comprising n bits and into a digital error signal ($y_e$) comprising m bits.

26. Method according to Claim 24 or Claim 25, **characterized in that** in order to generate the feedback signal ($y_{FB}$) the positive value of the error signal ($y_e$) is determined and filtered with the aid of a filter element (17) of the filter characteristic $\frac{1}{z+\alpha}$, which filter element is implemented by means of a time delay element (19), where $\alpha = 2^{-s}$, s being a natural number, and the output signal, shifted to the right by s bit positions, of the time delay element, being subtracted in each case from the input signal of the time delay element.

27. Method according to one of Claims 21 to 23, **characterized in that** steps a), b) and d) are designed as analogue processing stages.

28. Method according to Claim 27, **characterized in that** an analogue/digital conversion of the output signal ($x_{Q,a}$) of the addition is carried out in order to convert the output signal ($x_{Q,a}$) of the addition into a digital signal ($y_{A/D}$) comprising n bits.

29. Method according to Claim 27 or Claim 28, **characterized in that** the error signal ($y_{e,a}$) is obtained as an analogue error signal from the analogue output signal ($x_{Q,a}$) of the addition and the digital signal ($y_{A/D}$) back-converted into an analogue signal ($y_{D/A}$) and comprising n bits.

**Revendications**

1. Dispositif de suppression de cycles limites lors de la mise en forme de bruit qui comprend

   - un bloc (1, 21) de filtre pour la mise en forme de bruit ;
   - un additionneur (12, 30) à la première entrée duquel s'applique le signal ($Y_Q$, $Y_{Q,a}$) de résultat du bloc de filtre pour la mise en forme de bruit, à la deuxième entrée duquel s'applique un signal ($Y_{FB}$, $Y_{FB,a}$) de réaction et dont le signal ($X_Q$, $X_{Q,a}$) de sortie est envoyé à un étage (14, 33) diviseur ;
   - un étage (14, 33) diviseur qui transforme le signal ($X_Q$, $X_{Q,a}$) de sortie de l'additionneur en un signal ($Y$, $Y_{A/D}$) numérique comprenant n bits et en un signal ($Y_e$, $Y_{e,a}$) d'erreur, ainsi que
   - un bloc (13, 31) de réaction qui produit le signal ($Y_{FB}$, $Y_{FB,a}$) de réaction à partir du signal ($Y_e$, $Y_{e,a}$) d'erreur et l'envoi à l'additionneur (12, 30).

2. Dispositif suivant la revendication 1, **caractérisé en ce que** le bloc (1, 21) de filtre pour la mise en forme de bruit est constitué sous la forme de filtres de mise en forme de bruit à deux étages ou à trois étages.

3. Dispositif suivant la revendication 1 ou la revendication 2, **caractérisé en ce que** le bloc (13, 31) de réaction comprend un convertisseur (16, 37) de signes pour la détermination de la valeur positive du signal ($Y_e$, $Y_{e,a}$) d'erreur, ainsi qu'un élément (19) de temporisation.

4. Dispositif suivant l'une des revendications précédentes, **caractérisé en ce que** le bloc (13, 31) de réaction comprend un convertisseur (16, 37) de signes pour la détermination de la valeur positive du signal ($Y_e$, $Y_{e,a}$) d'erreur, ainsi qu'un élément (17, 38) de filtre ayant la fonction de transfert $\frac{1}{z+\alpha}$, $\alpha$ étant égal à $2^{-s}$ et s étant un entier naturel.

5. Dispositif suivant l'une des revendications précédentes, **caractérisé en ce que** le bloc (1) de filtre pour la mise en forme de bruit est un filtre numérique et **en ce que** l'additionneur (12), l'étage (14) diviseur et le bloc (13) de réaction sont réalisés en étages numériques de traitement du signal.

6. Dispositif suivant la revendication 5, **caractérisé en ce que** l'étage (14) diviseur met à disposition le signal ($Y_e$) d'erreur sous la forme d'un signal d'erreur numérique comprenant m bits.

7. Dispositif suivant la revendication 5 ou la revendication 6, **caractérisé en ce que** le convertisseur (16) de signes du bloc (13) de réaction détermine la valeur absolue du signal ($Y_e$) d'erreur.

8. Dispositif suivant la revendication 5 ou la revendication 6, **caractérisé en ce que** le convertisseur (16) de signes du bloc (13) de réaction détermine le complément à deux du signal ($Y_e$) d'erreur.

9. Dispositif suivant l'une des revendications 5 à 8, **caractérisé en ce que** l'élément (17) de filtre ayant la fonction de transfert $\frac{1}{z+\alpha}$, est réalisé au moyen d'un élément (19) temporisateur, $\alpha$ étant égal à $2^{-s}$ et s étant un entier naturel, et le signal de sortie, décalé vers la droite de s positions de bit, de l'élément (19) de temporisation étant soustrait, respectivement, du signal d'entrée de l'élément de temporisation.

10. Dispositif suivant l'une des revendications 5 à 9, **caractérisé en ce que**, lors de la détermination du signal ($Y_{FB}$) de réaction dans le bloc (13) de réaction, on effectue un calcul avec une précision augmenté d'au moins un bit supplémentaire peu significatif.

11. Dispositif suivant l'une des revendications 5 à 10, **caractérisé en ce que** le dispositif est réalisé au moyen d'un processeur numérique de signal.

12. Dispositif suivant l'une des revendications 5 à 10, **caractérisé en ce que** le dispositif est réalisé en montage en matériel.

13. Dispositif suivant l'une des revendications 5 à 12, **caractérisé en ce que** le dispositif est utilisé pour la mise en forme de signaux audio numérisés, notamment dans des récepteurs de radiocommunication mobiles.

14. Dispositif suivant l'une des revendications 1 à 4, **caractérisé en ce que** le bloc (21) de filtre pour la mise en forme de bruit est un filtre analogique et **en ce que** l'additionneur (30) et le bloc (31) de réaction sont réalisés en étages analogiques de traitement du signal.

15. Dispositif suivant la revendication 14, **caractérisé en ce que** l'étage (33) diviseur comprend, disposé à l'entrée, un convertisseur analogique/numérique de production du signal ($Y_{A/D}$) numérique comprenant n bits.

16. Dispositif suivant la revendication 14 ou la revendication 15, **caractérisé en ce que** le signal ($Y_{e,a}$) d'erreur est obtenu sous la forme d'un signal analogique d'erreur à partir du signal ($X_{Q,a}$) analogique de sortie de l'additionneur (30) et du signal ($Y_{A/D}$) numérique de l'étage (33) diviseur comprenant n bits retransformé en un signal ($Y_{D/A}$) analogique.

17. Dispositif suivant l'une des revendications 14 à 16, **caractérisé en ce que** l'additionneur (30) est réalisé au moyen d'un amplificateur opérationnel.

18. Dispositif suivant l'une des revendications 14 à 17, **caractérisé en ce que** le convertisseur (37) de signes est réalisé au moyen d'un redresseur.

19. Dispositif suivant l'une des revendications 14 à 18, **caractérisé en ce que** les étages analogiques de traitement du signal sont réalisés suivant la technique Switched-Capacitor.

20. Dispositif suivant l'une des revendications 14 à 19, **caractérisé en ce que** le dispositif est utilisé pour l'enregistrement numérique de signaux analogiques.

21. Procédé de suppression de cycles limites lors de la mise en forme de bruit, **caractérisé par** des stades suivants :

   a) filtrage du signal (X, $X_a$) d'entrée au moyen d'un bloc (1, 21) de filtre pour la mise en forme de bruit ;
   b) addition d'un signal ($Y_{FB}$, $Y_{FB,a}$) de réaction au signal ($Y_Q$, $Y_{Q,a}$) de résultat du bloc (1, 21) de filtre pour la mise en forme de bruit ;

   c) transformation du signal ($X_Q$, $X_{Q,a}$) de sortie de l'addition en un signal (Y, $Y_{A/D}$) numérique comprenant n bits et en un signal ($Y_e$, $Y_{e,a}$) d'erreur ;
   d) production à partir du signal ($Y_e$, $Y_{e,a}$) d'erreur du signal ($Y_{FB}$, $Y_{FB,a}$) de réaction.

22. Procédé suivant la revendication 21, **caractérisé en ce que**, pour la production du signal ($Y_{FB}$, $Y_{FB,a}$) de réaction, on détermine la valeur positive du signal ($Y_e$, $Y_{e,a}$) d'erreur et on la mémorise dans un élément (19) de temporisation.

23. Procédé suivant la revendication 21 ou la revendication 22, **caractérisé en ce que**, pour la production du signal ($Y_{FB}$, $Y_{FB,a}$) de réaction, on détermine la valeur positive du signal ($Y_e$, $Y_{e,a}$) d'erreur et on la filtre avec un élément (17, 38) de filtre ayant la caractéristique de filtrage $\dfrac{1}{z + \alpha}$, $\alpha$ étant égal à $2^{-s}$ et s étant un entier naturel.

24. Procédé suivant l'une des revendications 21 à 23, **caractérisé en ce que** l'on constitue les stades a) à d) sous la forme d'étages de traitement numérique.

25. Procédé suivant la revendication 24, **caractérisé en ce que** l'on transforme le signal ($X_Q$) de sortie de l'addition en un signal (Y) numérique comprenant n bits et en un signal ($Y_e$) numérique d'erreur comprenant m bits.

26. Procédé suivant la revendication 24 ou la revendication 25, **caractérisé en ce que**, pour la production du signal ($Y_{FB}$) de réaction, on détermine la valeur positive du signal ($Y_e$) d'erreur et on la filtre avec un élément (17) de filtre ayant la caractéristique de filtrage $\dfrac{1}{z + \alpha}$, qui est réalisé au moyen d'un élément (19) de temporisation, $\alpha$ étant égal à $2^{-s}$, s étant un entier naturel, et on soustrait le signal de sortie, décalé vers la droite de s positions de bit, de l'élément de temporisation, respectivement, du signal d'entrée de l'élément de temporisation.

27. Procédé suivant l'une des revendications 21 à 23, **caractérisé en ce que** les stades a), b) et d) sont constitués sous la forme d'étages analogiques de traitement.

28. Procédé suivant la revendication 27, **caractérisé en ce que**, pour transformer le signal ($X_{Q,a}$) de sortie de l'addition en un signal ($Y_{A/D}$) numérique comprenant n bits, on effectue une transformation analogique/numérique du signal ($X_{Q,a}$) de sortie de l'addition.

29. Procédé suivant la revendication 27 ou la revendication 28, **caractérisé en ce que** l'on obtient le signal ($Y_{e,a}$) d'erreur sous la forme d'un signal analogique d'erreur à partir du signal ($X_{Q,a}$) analogique de sortie de l'addition et du signal ($Y_{A/D}$) numérique comprenant n bits et retransformé en un signal ($Y_{D/A}$) analogique.

Fig.1A

EP 1 397 867 B1

Fig.1B

Fig.2A

Fig.2B

Fig.3

Fig.4A

Fig.4B